# EUROPEAN PATENT APPLICATION

(11) **EP 3 858 947 A1**
(43) Date of publication of application: **04.08.2021**
(21) Application number: 19865357.8
(22) Date of filing: 19.09.2019
(51) Int. Cl.: C09K 11/08, C09K 11/79, F21V 9/30, G02B 5/20, H01L 33/50, H01S 5/02, F21Y 115/30

(54) **WARM-COLOR COMPLEX PHOSPHOR, WAVELENGTH CONVERSION BODY, AND LIGHT EMITTING DEVICE**

(30) Priority: 26.09.2018 JP 2018179960
(71) Applicant: Panasonic Intellectual Property Management Co., Ltd., Osaka-shi, Osaka 540-6207 (JP)
(72) Inventor: NITTA Mitsuru, Osaka-shi Osaka 540-6207 (JP); OSHIO Shozo, Osaka-shi, Osaka 540-6207 (JP)
(74) Representative: Müller-Boré & Partner Patentanwälte PartG mbB
(86) International application number: PCT/JP2019/036779
(87) International publication number: WO 2020/066839

(57) **Abstract**

A warm-color complex phosphor includes: a Ce³⁺-activated orange phosphor that has an excitation peak within a blue wavelength range of 440 nm or more and less than 480 nm and has a fluorescence peak within an orange wavelength range of 580 nm or more and less than 610 nm; and a Ce³⁺-activated red phosphor that has an excitation peak within a green wavelength range of 500 nm or more and less than 550 nm and has a fluorescence peak within a red wavelength range of 610 nm or more and less than 660 nm. Preferably, the Ce³⁺-activated red phosphor is a nitride-based compound.

## Description

### TECHNICAL FIELD

The present disclosure relates to a warm-color complex phosphor, a wavelength converter and a light emitting device.

### BACKGROUND ART

Heretofore, there has been known a warm-color complex phosphor composed by combining a plurality of types of warm-color phosphors which radiate warm-color fluorescences of orange to red with one another (hereinafter, referred to as "warm-color complex phosphor"). Moreover, a wavelength converter and a light emitting device, which use this warm-color complex phosphor, have also been known. These warm-color complex phosphor, wavelength converter and light emitting device are used, for example, for solid-state illumination such as LED illumination.

Heretofore, a warm-color complex phosphor that uses a Eu²⁺-activated red phosphor and a Eu²⁺-activated orange phosphor has been known. For example, Patent Literature 1 discloses a warm-color complex phosphor that uses a Ca-α-SiALON:Eu²⁺ orange phosphor and a CaAlSiN₃:Eu²⁺ red phosphor. Moreover, Patent Literature 2 discloses a warm-color complex phosphor that uses a K₂SiF₆:Mn⁴⁺ red phosphor and a CaAlSiN₃:Eu²⁺ red phosphor. Furthermore, Patent Literature 3 discloses a warm-color complex phosphor that uses Sr,Ca)₂Si₅:N₈:Eu²⁺ red phosphor and a (Sr,Ba)LiAl₃N₄:Eu²⁺ red phosphor.

The above-described complex warm-color phosphors are those each formed by combining a plurality of the orange phosphors and the red phosphors, which have excitation peaks in the blue wavelength range, with one another. These complex warm-color phosphors have been developed for the purpose of turning illumination light to an electric bulb color, increasing light emission efficiency of high color-rendering illumination light, expanding a display color range of a display device, and suppressing a change of a color tone of a red fluorescent component, which follows a temperature rise of the phosphors.

### CITATION LIST

### PATENT LITERATURE

PTL 1: Japanese Patent No. 3837588
PTL 2: English translation of Japanese Unexamined Patent Application Publication No. 2016-503579
PTL 3: English translation of Japanese Unexamined Patent Application Publication No. 2017-536694

### SUMMARY OF INVENTION

### TECHNICAL PROBLEM

However, the above-described warm-color complex phosphors cannot greatly change the color tones of the warm-color fluorescent components even if changing a light color of excitation light. Specifically, the above-described warm-color complex phosphors cannot greatly change the color tones of the warm-color fluorescent components even if changing the light color of the excitation light from blue to green. Therefore, in the above-described warm-color complex phosphors, it has been difficult to obtain fluorescence with a desired color tone by such a simple operation as changing the light color of the excitation light.

The reason for this will be described. The Eu²⁺-activated warm-color complex phosphor for use in the above-described warm-color complex phosphors has, due to optical properties thereof, a light absorption band that has a relatively wide spectrum width over a wide wavelength range from violet through blue to green and has a peak in the vicinity of the wavelength range of blue. Here, shapes of the excitation spectra in the wavelength range of blue to green are similar to one another even if types of the Eu²⁺-activated warm-color complex phosphor are different from one another. The shapes of the excitation spectra are similar to each other, for example, even in either case where such light colors are similar to each other as in the Eu²⁺-activated red phosphor and the other Eu²⁺-activated red phosphor or where the light colors are different from each other as in the Eu²⁺-activated orange phosphor and the Eu²⁺-activated red phosphor.

Therefore, in the above-described warm-color complex phosphor that uses one type or two types or more of the Eu²⁺-activated warm-color complex phosphors and in a wavelength converter that uses this, even if the excitation light is changed from blue to green, only fluorescence intensities thereof just decrease, and the color tones of the warm-color fluorescent components cannot be greatly changed. Hence, the conventional warm-color complex phosphor and the wavelength converter that uses this have had a problem of not being able to obtain a variety of warm-color light components even if changing an intensity ratio of a blue light component and a green light component in the excitation light.

Moreover, it is desired that the light emitting device control the color tones (orange to red) of the warm-color fluorescent components by such a simple control as changing the intensity ratio of the blue light component and the green light component in the excitation light, and as a result, obtain a variety of warm-color light components. However, the light emitting device that uses the conventional warm-color complex phosphor has had a problem of not being able to obtain a variety of warm-color light components even if changing the above-described intensity ratio of the blue light component and the green light component.

Note that the warm-color light components greatly affect color rendering properties of the illumination light. Therefore, the conventional warm-color complex phosphor has usually used a plurality of types of warm-color phosphors different in color tone in combination with one another. However, in recent years, it has been desired that types of the warm-color phosphors be few for the purpose of facilitating adjustment work of a color tone of output light, and so on. Therefore, one type of warm-color complex phosphor that can easily emit a variety of color tones has been desired.

The present disclosure has been made in order to solve such a problem. It is an object of the present disclosure to provide a warm-color complex phosphor, a wavelength converter and a light emitting device, which are capable of obtaining a variety of warm-color light components by changing the intensity ratio of the blue light component and the green light component in the excitation light.

### SOLUTION TO PROBLEM

In order to solve the above-described problem, a warm-color complex phosphor according to a first aspect of the present disclosure includes: a Ce³⁺-activated orange phosphor that has an excitation peak within a blue wavelength range of 440 nm or more and less than 480 nm and has a fluorescence peak within an orange wavelength range of 580 nm or more and less than 610 nm; and a Ce³⁺-activated red phosphor that has an excitation peak within a green wavelength range of 500 nm or more and less than 550 nm and has a fluorescence peak within a red wavelength range of 610 nm or more and less than 660 nm.

A wavelength converter according to a second aspect of the present disclosure includes the above-described warm-color complex phosphor.

A light emitting device according to a third aspect of the present disclosure is one formed by combining the above-described warm-color complex phosphor or the above-described wavelength converter and an excitation source, which excites the warm-color complex phosphor, with each other.

### BRIEF DESCRIPTION OF DRAWINGS

FIG. 1 is a schematic diagram illustrating a warm-color complex phosphor according to a first embodiment.
FIG. 2 is an example of respective excitation spectra and respective fluorescence spectra of a first warm-color phosphor and a second warm-color phosphor.
FIG. 3 is an example of respective excitation spectra and respective fluorescence spectra of a Eu²⁺-activated orange phosphor and a Eu²⁺-activated red phosphor which constitute a conventional complex warm-color phosphor.
FIG. 4 is a schematic diagram illustrating a wavelength converter according to a second embodiment.
FIG. 5 is a schematic diagram illustrating a wavelength converter according to a third embodiment.
FIG. 6 is a schematic diagram illustrating a wavelength converter according to a fourth embodiment.
FIG. 7 is schematic diagrams of an example of light emitting devices according to a fifth embodiment.
FIG. 8 is a diagram illustrating respective excitation spectra and respective fluorescence spectra of the first warm-color phosphor and the second warm-color phosphor which are used in a simulation.
FIG. 9 is simulation results of fluorescence spectra in the case of excitation by pieces of monochromatic light in which a wavelength is changed within a wavelength range of 450 nm to 550 nm.
FIG. 10 is simulation results of fluorescence spectra in the case of using excitation light in which an intensity ratio of blue monochromatic light and green monochromatic light is changed.
FIG. 11 is spectral distribution maps of white excitation light radiated by three types of white light sources different in color tone from one another.
FIG. 12 is simulation results of fluorescence spectra in the case of using the three types of white excitation light illustrated in FIG. 11.

### DESCRIPTION OF EMBODIMENTS

A description will be given below of a warm-color complex phosphor, a wavelength converter and a light emitting device according to each of embodiments of the present disclosure with reference to the drawings. Note that any of the embodiments to be described below illustrates a preferable specific example of the present disclosure. That is, numeric values, shapes, materials, constituents, arrangement positions and connection modes of the constituents, and the like, which are illustrated in the following embodiments, are examples, and are not intended to limit the present disclosure. Therefore, among the constituents in the embodiments to be described below, constituents which are not described in the independent claims showing the top-level concept of the present disclosure are described as arbitrary constituents.

Note that the respective drawings are schematic diagrams, and are not always strictly illustrated. Moreover, in the respective drawings, the same reference numerals are assigned to substantially the same constituents, and duplicate descriptions will be omitted or simplified.

### [Warm-color complex phosphor]

### (First embodiment)

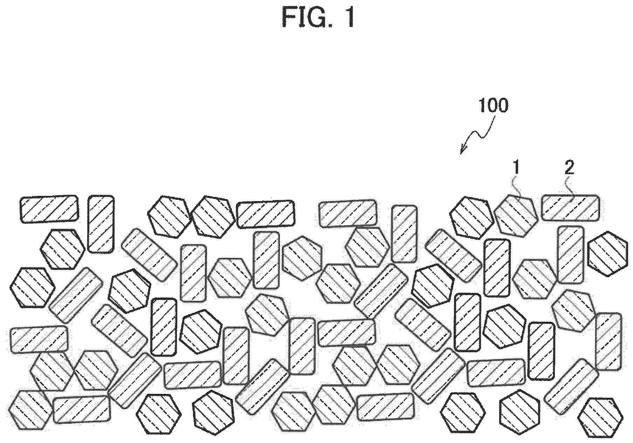

A warm-color complex phosphor according to a first embodiment will be described with reference to the drawings. FIG. 1 is a schematic diagram illustrating a warm-color complex phosphor according to the first embodiment. As illustrated in FIG. 1, a warm-color complex phosphor 100 includes a first warm-color phosphor 1 and a second warm-color phosphor 2. Both of the first warm-color phosphor 1 and the second warm-color phosphor 2 have shapes of powders each of which is an aggregate of fine particles. The warm-color complex phosphor 100 is a mixture of the powdery first warm-color phosphor 1 and the powdery second warm-color phosphor 2.

Note that, in FIG. 1, the particles of the first warm-color phosphor 1 are represented by hexagons, and the particles of the second warm-color phosphor 2 are represented by rectangles. However, FIG. 1 is a schematic diagram, and the particles of the first warm-color phosphor 1 and the particles of the second warm-color phosphor 2 are not limited to the hexagons and the rectangles.

### <First warm-color phosphor>

The first warm-color phosphor 1 is a Ce³⁺-activated orange phosphor that has an excitation peak within a blue wavelength range of 440 nm or more and less than 480 nm and has a fluorescence peak within an orange wavelength range of 580 nm or more and less than 610 nm.

The first warm-color phosphor 1 has an excitation peak within a blue wavelength range of 440 nm or more and less than 480 nm, preferably 445 nm or more and less than 475 nm. Moreover, the first warm-color phosphor 1 has a fluorescence peak within an orange wavelength range of 580 nm or more and less than 610 nm, preferably 590 nm or more and less than 605 nm.

The first warm-color phosphor 1 has an excitation peak within the above-described wavelength range and has a fluorescence peak within the above-described wavelength range, and accordingly, can absorb a blue light component in excitation light and convert the blue light component into an orange light component.

The first warm-color phosphor 1 is a Ce³⁺-activated orange phosphor. Generally, the Ce³⁺-activated phosphor has a narrower excitation band than a Eu²⁺-activated phosphor. In this embodiment, the Ce³⁺-activated orange phosphor is used as the first warm-color phosphor 1, whereby the first warm-color phosphor 1 is not excited by a green light component that excites the second warm-color phosphor 2, but is excited by only the above-described blue light component with an excitation band of which width is narrow, and can radiate orange fluorescence. That is, in this embodiment, fluorescence intensity of the obtained orange light can be changed by changing intensity of the blue light component in the excitation light.

As the Ce³⁺-activated orange phosphor, garnet-type silicate is preferably used, and a Lu₂CaMg₂(SiO₄)₃-based compound is more preferably used. Here, the garnet-type silicate means a silicate that has a crystal structure of garnet.

Moreover, the Lu₂CaMg₂(SiO₄)₃-based compound means a compound that has a crystal structure of Lu₂CaMg₂(SiO₄)₃ or a Lu₂CaMg₂(SiO₄)₃ solid solution in which an end member is Lu₂CaMg₂(SiO₄)₃. For example, the Lu₂CaMg₂(SiO₄)₃-based compound is a concept including: a compound in which another element is substituted for a part or all of elements which constitute a crystal of a Lu₂CaMg₂(SiO₄)₃:Ce³⁺ orange phosphor; and a compound that contains a trace amount of an impurity element in the above-described crystal.

The above-described Ce³⁺-activated orange phosphor is mainly composed of an oxide, and accordingly, industrial production thereof is easy. Moreover, as the above-described Ce³⁺-activated orange phosphor, one is known, which is excitable by a blue light component since the one has a relatively small energy difference, that is, a relatively small Stokes shift between light absorption and fluorescence, and radiates orange fluorescence with a fluorescence peak wavelength of approximately 600 nm. Therefore, when the above-described garnet-type silicate is used as the above-described Ce³⁺-activated orange phosphor, it is easy to produce the warm-color complex phosphor 100.

Moreover, as the Lu₂CaMg₂(SiO₄)₃-based compound, for example, a Lu₂CaMg₂(SiO₄)₃:Ce³⁺ orange phosphor in which temperature quenching is good and a phosphor formed by modifying this in terms of composition are known. Therefore, when the Lu₂CaMg₂(SiO₄)₃-based compound is used as the Ce³⁺-activated orange phosphor, it is easy to produce the warm-color complex phosphor 100 that maintains highly efficient fluorescence even at high temperature.

As the Lu₂CaMg₂(SiO₄)₃-based compound, for example, there are used: a Lu₂CaMg₂(SiO₄)₃:Ce³⁺; a yellow or orange phosphor as a solid solution of the Lu₂CaMg₂(SiO₄)₃:Ce³⁺ orange phosphor and a Lu₃Al₂(AlO₄)₃:Ce³⁺ green phosphor; and the like.

### <Second warm-color phosphor>

The second warm-color phosphor 2 is a Ce³⁺-activated red phosphor that has an excitation peak within a green wavelength range of 500 nm or more and less than 550 nm and has a fluorescence peak within a red wavelength range of 610 nm or more and less than 660 nm.

The second warm-color phosphor 2 has an excitation peak within a green wavelength range of 500 nm or more and less than 550 nm, preferably 510 nm or more and less than 540 nm. Moreover, the second warm-color phosphor 2 has a fluorescence peak within a red wavelength range of 610 nm or more and less than 660 nm, preferably 620 nm or more and less than 650 nm.

The second warm-color phosphor 2 has an excitation peak within the above-described wavelength range and has a fluorescence peak within the above-described wavelength range, and accordingly, can absorb a green light component in excitation light and convert the green light component into a red light component.

The second warm-color phosphor 2 is a Ce³⁺-activated red phosphor. Generally, the Ce³⁺-activated phosphor has a narrower excitation band than the Eu²⁺-activated phosphor. In this embodiment, the Ce³⁺-activated red phosphor is used as the second warm-color phosphor 2, whereby the second warm-color phosphor 2 is not excited by a blue light component that excites the first warm-color phosphor 1, but is excited by only the above-described green light component with an excitation band of which width is narrow, and can radiate red fluorescence. That is, in this embodiment, fluorescence intensity of the obtained red light can be changed by changing intensity of the green light component in the excitation light.

As the Ce³⁺-activated red phosphor, a nitride-based compound is preferably used, and a La₃Si₆N₁₁-type nitride that has a La₃Si₆N₁₁-type crystal structure is more preferably used. Here, the nitride-based compound means a compound that has a crystal structure containing nitrogen. As the nitride-based compound, for example, a nitride or an oxynitride-based compound is used.

As the above-described nitride-based compound, one is known, which radiates fluorescence favorable in terms of red purity since the one has a fluorescence peak wavelength exceeding 620 nm, and is excitable by a green light component since the one has a small energy difference, that is, a small Stokes shift between light absorption and fluorescence. Therefore, when the above-described nitride-based compound is used as the Ce³⁺-activated red phosphor, it is easy to produce the warm-color complex phosphor 100.

As the nitride-based compound, for example, the La₃Si₆N₁₁-type nitride-based compound is used. Here, the La₃Si₆N₁₁-type nitride-based compound means a nitride-based compound that has a La₃Si₆N₁₁-type crystal structure.

As the La₃Si₆N₁₁-type nitride-based compound, for example, a La₃(Si,Al)₆N₁₁:Ce³⁺-red phosphor in which temperature quenching is good, a red phosphor with a composition similar thereto, in which another element is substituted for a part of elements which constitute this crystal, and the like are used. The La₃(Si,Al)₆N₁₁:Ce³⁺-red phosphor is preferable since this phosphor can maintain high efficiency even at high temperature.

### <Combination of first warm-color phosphor and second warm-color phosphor>

In the warm-color complex phosphor 100, preferably, the Ce³⁺-activated orange phosphor that is the first warm-color phosphor 1 is the Lu₂CaMg₂(SiO₄)₃-based compound, and the Ce³⁺-activated red phosphor that is the second warm-color phosphor 2 is the La₃Si₆N₁₁-type nitride-based compound.

The Ce³⁺-activated orange phosphor composed of the chemical formula Lu₂CaMg₂(SiO₄)₃-based compound and the Ce³⁺-activated red phosphor composed of the La₃Si₆N₁₁-type nitride-based compound are similar to each other in behavior of the temperature quenching.

Therefore, when the Lu₂CaMg₂(SiO₄)₃-based compound and the La₃Si₆N₁₁-type nitride-based compound are used in combination with each other, a variation of a color tone of the warm-color light component, which follows a temperature rise and the like of the warm-color complex phosphor 100, decreases. Moreover, according to the warm-color complex phosphor 100 with such a configuration, with regard to a variation of a color tone of a spectral distribution in the orange to red wavelength range with respect to a phosphor temperature, a difference thereof between the time of design and the time of use decreases, and accordingly, a warm-color complex phosphor is obtained, which is excellent in stability of the color tone of the warm-color fluorescent component. 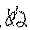

### <Form of warm-color complex phosphor>

The warm-color complex phosphor 100 illustrated in FIG. 1 is a powder mixture that is a mixture of the powdery first warm-color phosphor 1 and the powdery second warm-color phosphor 2. When the form of the warm-color complex phosphor is such a powder mixture as the warm-color complex phosphor 100, the warm-color complex phosphor 100 can be generated by only mixing the first warm-color phosphor 1 and the powdery second warm-color phosphor 2 with each other, and it is easy to produce the warm-color complex phosphor 100, and accordingly, this is preferable.

Note that the form of the warm-color complex phosphor of the present disclosure is not particularly limited, and can be a form other than the mixture as the warm-color complex phosphor 100. For example, the form of the warm-color complex phosphor of the present disclosure can be a mixture of a particulate first warm-color phosphor 1 and a particulate second warm-color phosphor 2, which are composed of particles larger than the fine particles which constitute the powder of the warm-color complex phosphor 100. Moreover, the form of the warm-color complex phosphor of the present disclosure can be, for example, such a bulk as ceramics obtained by sintering or firing the mixture of the powdery first warm-color phosphor 1 and the powdery second warm-color phosphor 2.

### <Components of first warm-color phosphor and second warm-color phosphor>

According to needs, the warm-color complex phosphor 100 may include another phosphor than the first warm-color phosphor 1 and the second warm-color phosphor 2.

As another phosphor than the first warm-color phosphor 1 and the second warm-color phosphor 2, for example, a phosphor is used, which radiates fluorescence with a color tone different from orange and red, for example, with a color of blue or green. This phosphor may be a Ce³⁺-activated phosphor, or may not be a Ce³⁺-activated phosphor.

Moreover, as another phosphor than the first warm-color phosphor 1 and the second warm-color phosphor 2, for example, a phosphor is used, which has an activating substance different from Ce³⁺. A color tone of fluorescence of this phosphor is not particularly limited.

### <Excitation spectrum and fluorescence spectrum>

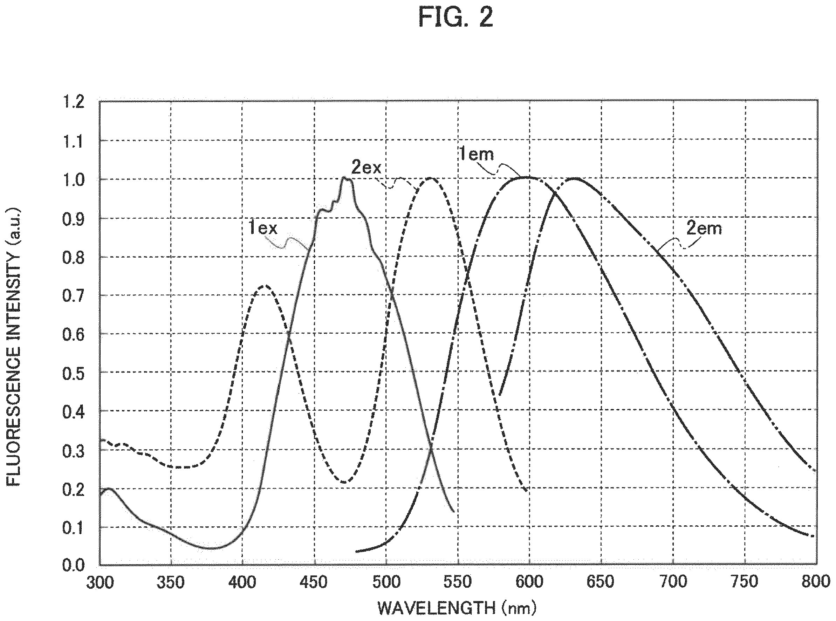

FIG. 2 is an example of respective excitation spectra and respective fluorescence spectra of the first warm-color phosphor and the second warm-color phosphor. Specifically, FIG. 2 is an example of excitation spectra and fluorescence spectra when the Lu₂CaMg₂(SiO₄)₃:Ce³⁺ orange phosphor is used as the first warm-color phosphor 1 and the La₃(Si,Al)₆N₁₁:Ce³⁺ red phosphor is used as the second warm-color phosphor 2.

In FIG. 2, the excitation spectrum of the Lu₂CaMg₂(SiO₄)₃:Ce³⁺ orange phosphor that is the first warm-color phosphor 1 is represented as 1ex, and the fluorescence spectrum of the same phosphor is represented as 1em. Moreover, the excitation spectrum of the La₃(Si,Al)6N₁₁:Ce³⁺ red phosphor that is the second warm-color phosphor 2 is represented as 2ex, and the fluorescence spectrum of the same phosphor is represented as 2em.

From FIG. 2, it is seen that the first warm-color phosphor 1 has an excitation peak within the blue wavelength range in which the excitation spectrum (1ex) is in 440 nm or more and less than 480 nm, and has a fluorescence peak within the orange wavelength range in which the fluorescence spectrum (1em) is in 580 nm or more and less than 610 nm. Therefore, it is seen that the first warm-color phosphor 1 is a phosphor that absorbs a blue light component within the wavelength range of 440 nm or more and less than 480 nm, and performs wavelength conversion for the blue light component into orange light within the above-described wavelength range.

Moreover, the second warm-color phosphor 2 has an excitation peak within the green wavelength range in which the excitation spectrum (2ex) is in 500 nm or more and less than 550 nm, and has a fluorescence peak within the red wavelength range in which the fluorescence spectrum (2em) is in 610 nm or more and less than 660 nm. Therefore, it is seen that the second warm-color phosphor 2 is a phosphor that absorbs a green light component within the above-described wavelength range, and performs wavelength conversion for the green light component into red light within the above-described wavelength range.

### <Functions>

A detailed study will be given below of the graph illustrated in FIG. 2. Specifically, in the graph illustrated in FIG. 2, functions in the wavelength range where the color tone of the excitation light is blue to green, and specifically, in the excitation wavelength range of 470 nm or more and less than 530 nm will be studied.

From the excitation spectrum 1ex of FIG. 2, it is seen that the first warm-color phosphor 1 has an excitation peak in the vicinity of 470 nm and exhibits a tendency in which fluorescence intensity of orange light decreases as the excitation wavelength becomes longer in the excitation wavelength range of 470 nm or more and less than 530 nm.

Meanwhile, from the excitation spectrum 2ex of FIG. 2, it is seen that the second warm-color phosphor 2 has an excitation peak in the vicinity of 530 nm and exhibits a tendency in which fluorescence intensity of red light increases as the excitation wavelength becomes longer in the excitation wavelength range of 470 nm or more and less than 530 nm.

Therefore, in the warm-color complex phosphor 100 including the first warm-color phosphor 1 and the second warm-color phosphor 2, the fluorescence intensities of the obtained orange light and red light can be changed by changing an intensity ratio of the blue light component and the green light component in the excitation light. Moreover, in the warm-color complex phosphor 100, the fluorescence intensities of the obtained orange light and red light can be changed also by changing the excitation wavelength in the blue to green wavelength range of the excitation light.

That is, according to the warm-color complex phosphor 100, it is possible to change the color tone of the orange to red light component, which is radiated from the warm-color complex phosphor 100, by changing the intensity ratio of the blue light component and the green light component in the excitation light and changing the excitation wavelength in the blue to green wavelength range of the excitation light.

A description will be given below of functions brought by changing the intensity ratio of the blue light component and the green light component in the excitation light and the functions brought by changing the excitation wavelength in the blue to green wavelength range of the excitation light. Note that, in the following description, it is assumed that, as illustrated in FIG. 2, all of peak values of the excitation spectrum 1ex and fluorescence spectrum 1em of the first warm-color phosphor 1 and of the excitation spectrum 2ex and fluorescence spectrum 2em of the second warm-color phosphor 2 are 1.0.

First, a description will be given of the functions brought by changing the intensity ratio of the blue light component and the green light component in the excitation light.

When the warm-color complex phosphor 100 is excited by excitation light in which intensity of the blue light component with a wavelength of 470 nm is greatly larger than intensity of the green light component with a wavelength of 530 nm, the first warm-color phosphor 1 is excited efficiently, and radiates orange fluorescence with a relatively large intensity. Meanwhile, the second warm-color phosphor 2 is not excited efficiently, and radiates red fluorescence with a relatively small intensity. As a result, in the case of being excited by the above-described excitation light, the complex warm-color phosphor 100 radiates warm-color fluorescence in which a ratio of the orange fluorescent component is larger than that of the red fluorescent component.

Moreover, when the warm-color complex phosphor 100 is excited by excitation light in which the intensity of the blue light component with a wavelength of 470 nm is greatly smaller than the intensity of the green light component with a wavelength of 530 nm, the first warm-color phosphor 1 is not excited efficiently, and radiates orange fluorescence with a relatively small intensity. Meanwhile, the second warm-color phosphor 2 is excited efficiently, and radiates red fluorescence with a relatively large intensity. As a result, in the case of being excited by the above-described excitation light, the complex warm-color phosphor 100 radiates warm-color fluorescence in which a ratio of the red fluorescent component is larger than that of the orange fluorescent component.

Furthermore, when the warm-color complex phosphor 100 is excited by excitation light in which the intensity of the blue light component with a wavelength of 470 nm and the intensity of the green light component with a wavelength of 530 nm are equivalent to each other, both of the first warm-color phosphor 1 and the second warm-color phosphor 2 are excited efficiently, and radiate orange and red fluorescences which have substantially the same intensity. As a result, in the case of being excited by the above-described excitation light, the complex warm-color phosphor 100 radiates reddish orange fluorescence in which the orange and red fluorescent components are present in an equivalent ratio.

As described above, according to the complex warm-color phosphor 100, it is possible to greatly change the color tone of the obtained warm-color light component by appropriately adjusting the intensities of the blue light component and the green light component in the excitation light that excites the warm-color complex phosphor 100.

Note that the change of the intensity ratio of the blue light component and the green light component in the excitation light and the change of the spectral distribution of complex light as the excitation light can be controlled relatively easily, for example, by either or both of use of a plurality of types of solid-state light emitting elements different in color tone from one another and use of a plurality of types of phosphors different in color tone from one another. Specifically, the above-described intensity ratio and the above-described spectral distribution can be controlled relatively easily by use of a plurality of types of solid-state light emitting elements different in color tone from one another, use of a plurality of types of phosphors different in color tone from one another, combination of the solid-state light emitting elements different in color tone from one another and the phosphors different in color tone from one another, and the like. Here, as the solid-state light emitting elements, light emitting diodes, laser diodes and the like are used.

In the warm-color complex phosphor 100, desirably, the wavelength of the excitation peak of the blue light component and the wavelength of the excitation peak of the green light component are separated from each other by usually 20 nm or more, preferably 30 nm or more, preferably 40 nm or more. When the wavelengths of the excitation peaks of the blue light component and the green light component are separated from each other by 20 nm or more, then things become less likely to occur that the second warm-color phosphor 2 is unintentionally excited by the blue light component, and that the first warm-color phosphor 1 is unintentionally excited by the green light component.

Therefore, when the wavelengths of the excitation peaks of the blue light component and the green light component are separated from each other by 20 nm or more, there increases accuracy of the control of the color tone of the warm-color light component, which is obtained by changing the intensity ratio of the blue light component and the green light component in the excitation light.

Second, a description will be given of the functions brought by changing the excitation wavelength in the blue to green wavelength range of the excitation light.

For example, considered is the case of exciting the warm-color complex phosphor 100 by excitation light with a wavelength of 500 nm, which is located at an intermediate position between the blue light component with a wavelength of 470 nm and the green light component with a wavelength of 530 nm. From FIG. 2, it is seen that a difference between the fluorescence intensity of the excitation spectrum 1ex of the first warm-color phosphor 1 at the wavelength of 500 nm and the fluorescence intensity of the excitation spectrum 2ex of the second warm-color phosphor 2 at the same wavelength is small. Therefore, when the warm-color complex phosphor 100 is excited by the excitation light with a wavelength of 500 nm, the first warm-color phosphor 1 and the second warm-color phosphor 2 are excited to the same degree, and radiate orange fluorescence and red fluorescence, both of which have the same degree of intensity, respectively. As a result, in the case of being excited by the above-described excitation light, the complex warm-color phosphor 100 will radiate reddish orange fluorescence in which the orange and red fluorescent components are present in an equivalent ratio.

As described above, according to the complex warm-color phosphor 100, it is possible to greatly change the color tone of the warm-color light component by also appropriately adjusting the wavelength of the excitation light in the blue to green wavelength range, which excites the warm-color complex phosphor 100.

Note that the change of the peak wavelength of the light component, which covers blue to green and excites the complex warm-color phosphor 100, can be controlled relatively easily, for example, by either or both of use of a plurality of types of solid-state light emitting elements different in fluorescence peak from one another and use of a plurality of types of phosphors different in fluorescence peak from one another.

As described above, the complex warm-color phosphor 100 can generate a variety of warm-color light components by performing the change of the intensity ratio of the blue light component and the green light component in the excitation light and the change of the excitation wavelength in the blue to green wavelength range of the excitation light. Therefore, the complex warm-color phosphor 100 is suitable for illumination design for which a variety of warm-color light components different for each purpose.

### <Excitation spectrum and fluorescence spectrum of conventional complex warm-color phosphor>

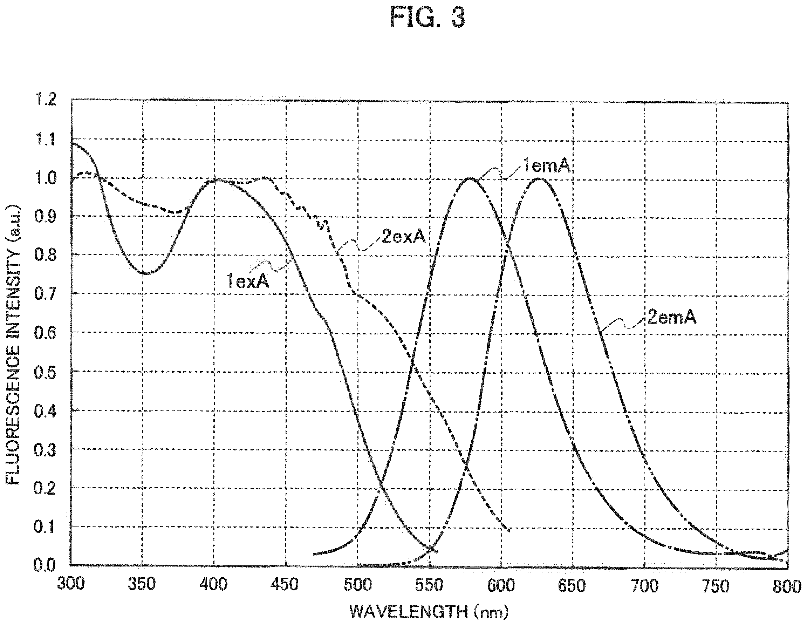

Note that, for reference, excitation spectra and fluorescence spectra of a Eu²⁺-activated orange phosphor and a Eu²⁺-activated red phosphor which constitute the conventional complex warm-color phosphor are shown. FIG. 3 is an example of the respective excitation spectra and the respective fluorescence spectra of the Eu²⁺-activated orange phosphor and the Eu²⁺-activated red phosphor which constitute the conventional complex warm-color phosphor. Here, the Eu²⁺-activated orange phosphor is Ca-α-SiALON:Eu²⁺, and the Eu²⁺-activated red phosphor is (Sr,Ca)AlSiN₃:Eu²⁺).

In FIG. 3, the excitation spectrum of the Ca-α-SiALON:Eu²⁺ orange phosphor that is the conventional Eu²⁺-activated orange phosphor is represented as 1exA, and the fluorescence spectrum of the same phosphor is represented as 1emA. Moreover, the excitation spectrum of the (Sr,Ca)AlSiN₃:Eu²⁺) red phosphor that is the conventional Eu²⁺-activated red phosphor is represented as 2exA, and the fluorescence spectrum of the same phosphor is represented as 2emA.

From FIG. 3, it is seen that the conventional Eu²⁺-activated orange phosphor has an excitation peak in the vicinity of a wavelength of 400 nm at which the excitation spectrum (1 exA) is a violet light component. Moreover, the conventional Eu²⁺-activated orange phosphor has a fluorescence peak in the vicinity of 580 nm at which the fluorescence spectrum (1emA) is within the orange wavelength range. Therefore, it is seen that the conventional Eu²⁺-activated orange phosphor is a phosphor that absorbs violet light and performs wavelength conversion for the violet light into orange light.

Moreover, the conventional Eu²⁺-activated red phosphor has an excitation peak in a wavelength of 400 nm to 450 nm in which the excitation spectrum (2exA) is a light component that covers violet to blue, and has a fluorescence peak in the vicinity of 625 nm in which the fluorescence spectrum (2emA) is in the red wavelength range. Therefore, it is seen that the conventional Eu²⁺-activated red phosphor is a phosphor that absorbs violet to blue light and performs wavelength conversion for the violet to blue light into red light.

### <Functions of conventional complex warm-color phosphor>

A detailed study will be given below of the graph illustrated in FIG. 3. Specifically, in the graph illustrated in FIG. 3, functions in the wavelength range where the color tone of the excitation light is blue to green, and specifically, in the excitation wavelength range of 470 nm or more and less than 530 nm will be studied.

From the excitation spectrum 1exA of FIG. 3, it is seen that, due to optical properties of Eu²⁺, the conventional Eu²⁺-activated orange phosphor exhibits a tendency in which fluorescence intensity of orange light decreases as the excitation wavelength becomes longer in the excitation wavelength range of 470 nm or more and less than 530 nm.

Meanwhile, from the excitation spectrum 2exA of FIG. 3, it is seen that, due to the optical properties of Eu²⁺, the conventional Eu²⁺-activated red phosphor exhibits a tendency in which fluorescence intensity of red light decreases as the excitation wavelength becomes longer in the excitation wavelength range of 470 nm or more and less than 530 nm.

As described above, it is seen that, due to the optical properties of Eu²⁺, each of the conventional Eu²⁺-activated orange phosphor and the conventional Eu²⁺-activated red phosphor exhibits such a tendency in which the fluorescence intensity of the orange light or the red light decreases as the excitation wavelength becomes longer in the excitation wavelength range of 470 nm or more and less than 530 nm.

Therefore, in the conventional complex warm-color phosphor including the Eu²⁺-activated orange phosphor and the Eu²⁺-activated red phosphor, the fluorescence intensities of the obtained orange light and red light cannot be changed by changing the intensity ratio of the blue light component and the green light component in the excitation light. Moreover, in the conventional complex warm-color phosphor, the fluorescence intensities of the obtained orange light and red light cannot be changed even by changing the excitation wavelength in the blue to green wavelength range of the excitation light.

### <Effect>

According to the warm-color complex phosphor 100, a variety of warm-color light components can be obtained by changing the intensity ratio of the blue light component and the green light component in the excitation light.

### [Wavelength converter]

### (Second embodiment)

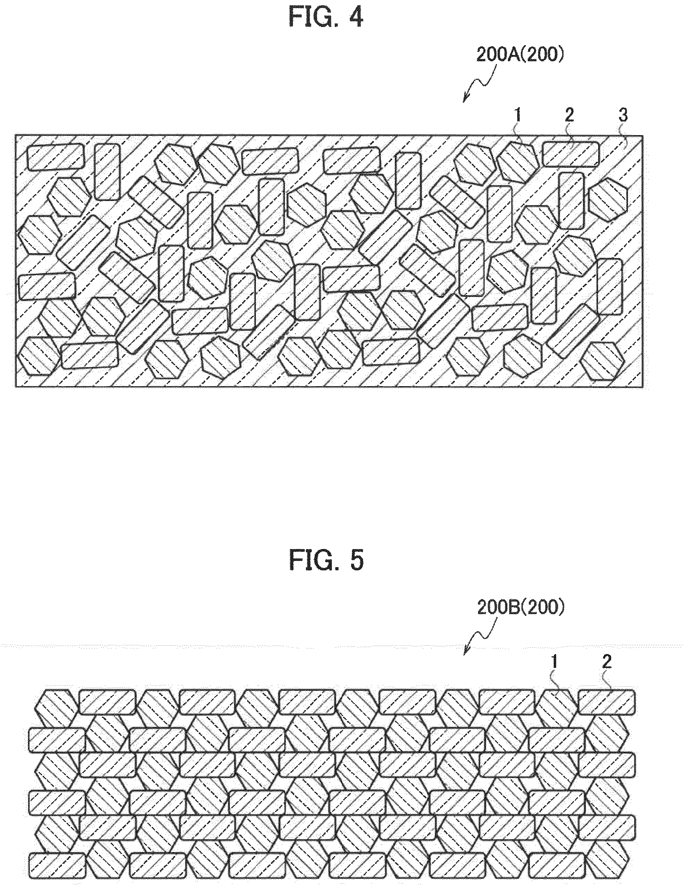

A description will be given of a wavelength converter according to a second embodiment with reference to the drawings. FIG. 4 is a schematic diagram illustrating the wavelength converter according to the second embodiment. As illustrated in FIG. 4, a wavelength converter 200A (200) includes a first warm-color phosphor 1, a second warm-color phosphor 2 and a transparent resin 3. Specifically, the wavelength converter 200A is one in which the first warm-color phosphor 1 and the second warm-color phosphor 2 are dispersed into the cured transparent resin 3.

Here, the first warm-color phosphor 1 and the second warm-color phosphor 2 which constitute the wavelength converter 200A are the same as the first warm-color phosphor 1 and the second warm-color phosphor 2 which constitute the warm-color complex phosphor 100 according to the first embodiment. Therefore, the wavelength converter 200A includes the warm-color complex phosphor 100.

The first warm-color phosphor 1 and the second warm-color phosphor 2 which constitute the wavelength converter 200A as described above are the same as the first warm-color phosphor 1 and the second warm-color phosphor 2 which constitute the warm-color complex phosphor 100 according to the first embodiment. Therefore, in the following description of the wavelength converter 200A according to this embodiment, the description of the first warm-color phosphor 1 and the second warm-color phosphor 2 will be omitted or simplified.

### <Transparent resin>

As the transparent resin 3, for example, silicon resin, epoxy resin and the like are used. Between them, the silicon resin is preferable since the silicon resin is excellent in heat resistance and durability.

Note that, when the wavelength converter 200A is made of only an inorganic material, the wavelength converter 200A becomes excellent in thermal conductivity, in which high heat dissipation design is easy, and accordingly, this is preferable. That is, in the wavelength converter 200A, preferably, the transparent resin 3 is made of an inorganic material.

Preferably, the wavelength converter 200A does not include another substance other than phosphors, and particularly, another substance other than the first warm-color phosphor 1 and the second warm-color phosphor 2. In the wavelength converter 200A that has such a configuration, factors to lose photons by light absorption are completely eliminated, and accordingly, it becomes easy to increase an output thereof. Moreover, the wavelength converter 200A that has such a configuration absorbs excitation light efficiently, and can thereby increase an output ratio of the fluorescent component subjected to wavelength conversion by the wavelength converter 200. Therefore, the wavelength converter 200A that has such a configuration becomes a wavelength converter suitable for a reflection-type light emitting device.

Moreover, preferably, the wavelength converter 200A includes a translucent inorganic compound as another substance than the phosphors. As the translucent inorganic compound, for example, alumina and silica are used.

The wavelength converter 200A that has such a configuration makes it easy for the excitation light to optically pass therethrough, and accordingly, makes it difficult to inhibit such optical transmission of the excitation light. Therefore, the wavelength converter 200A that has such a configuration becomes a wavelength converter suitable for a transmission-type light emitting device.

### <Functions>

Functions of the wavelength converter 200A, which relate to excitation and fluorescence, are the same as the functions of the warm-color complex phosphor 100 according to the first embodiment. Therefore, a description of the functions of the wavelength converter 200A, which relate to excitation and fluorescence, will be omitted.

### <Effects>

According to the wavelength converter 200A, a variety of warm-color light components can be obtained by changing the intensity ratio of the blue light component and the green light component in the excitation light.

Moreover, the wavelength converter 200A radiates the fluorescence including the orange to red light component, and accordingly, becomes a wavelength converter suitable for the purpose such as illumination and display.

### [Wavelength converter]

### (Third embodiment)

A description will be given of a wavelength converter according to a third embodiment with reference to the drawings. FIG. 5 is a schematic diagram illustrating the wavelength converter according to the second embodiment. As illustrated in FIG. 5, a wavelength converter 200B (200) includes a first warm-color phosphor 1 and a second warm-color phosphor 2. Specifically, the wavelength converter 200B is one in which the first warm-color phosphor 1 and the second warm-color phosphor 2 are brought into close contact with each other.

Note that, in FIG. 5, particles of the first warm-color phosphor 1 and particles of the second warm-color phosphor 2 form a regular arrangement of being alternately arrayed in the transverse direction and the longitudinal direction in this drawing. However, FIG. 5 is a schematic diagram, and in the wavelength converter 200B, the array of the particles of the first warm-color phosphor 1 and the particles of the second warm-color phosphor 2 does not need to be regular as long as the particles of the first warm-color phosphor 1 and the particles of the second warm-color phosphor 2 are in close contact with each other.

In the wavelength converter 200B, the first warm-color phosphor 1 and the second warm-color phosphor 2 which constitute the wavelength converter 200B are the same as the first warm-color phosphor 1 and the second warm-color phosphor 2 which constitute the warm-color complex phosphor 100 according to the first embodiment. Therefore, the wavelength converter 200B includes the warm-color complex phosphor 100.

The first warm-color phosphor 1 and the second warm-color phosphor 2 which constitute the wavelength converter 200B as described above are the same as the first warm-color phosphor 1 and the second warm-color phosphor 2 which constitute the warm-color complex phosphor 100 according to the first embodiment. Therefore, in the following description of the wavelength converter 200B according to this embodiment, the description of the first warm-color phosphor 1 and the second warm-color phosphor 2 will be omitted or simplified.

### <Close contact of first warm-color phosphor and second warm-color phosphor>

As a method for bringing the first warm-color phosphor 1 and the second warm-color phosphor 2 into close contact with each other, for example, a method of sintering the first warm-color phosphor 1 and the second warm-color phosphor 2 to each other is used.

As such a method for sintering the first warm-color phosphor 1 and the second warm-color phosphor 2 to each other, for example, a method of compression-molding mixed powder of the first warm-color phosphor 1 and the second warm-color phosphor 2 and thereafter heating and cooling a compression-molded body thus obtained is used.

Thus, the wavelength converter 200B in which the particles of the first warm-color phosphor 1 and the particles of the second warm-color phosphor 2 are in close contact with each other by sintering, the wavelength converter 200B being illustrated in FIG. 5, is obtained.

Note that, when the wavelength converter 200B is made of only an inorganic material, the wavelength converter 200B becomes excellent in thermal conductivity, in which high heat dissipation design is easy, and accordingly, this is preferable.

Preferably, the wavelength converter 200B does not include another substance other than phosphors, and particularly, another substance other than the first warm-color phosphor 1 and the second warm-color phosphor 2. In the wavelength converter 200B that has such a configuration, factors to lose photons by light absorption are completely eliminated, and accordingly, it becomes easy to increase an output thereof. Moreover, the wavelength converter 200B that has such a configuration absorbs excitation light efficiently, and can thereby increase an output ratio of the fluorescent component subjected to wavelength conversion by the wavelength converter 200B. Therefore, the wavelength converter 200B that has such a configuration becomes a wavelength converter suitable for a reflection-type light emitting device.

Moreover, preferably, the wavelength converter 200B includes a translucent inorganic compound as another substance than the phosphors. As the translucent inorganic compound, for example, alumina and silica are used.

The wavelength converter 200B that has such a configuration makes it easy for the excitation light to optically pass therethrough, and accordingly, makes it difficult to inhibit such optical transmission of the excitation light. Therefore, the wavelength converter 200B that has such a configuration becomes a wavelength converter suitable for a transmission-type light emitting device.

### <Functions>

Functions of the wavelength converter 200B, which relate to excitation and fluorescence, are the same as the functions of the warm-color complex phosphor 100 according to the first embodiment. Therefore, a description of the functions of the wavelength converter 200A, which relate to excitation and fluorescence, will be omitted.

### <Effects>

According to the wavelength converter 200B, a variety of warm-color light components can be obtained by changing the intensity ratio of the blue light component and the green light component in the excitation light.

Moreover, the wavelength converter 200B radiates the fluorescence including the orange to red light component, and accordingly, becomes a wavelength converter suitable for the purpose such as illumination and display.

### [Wavelength converter]

### (Fourth embodiment)

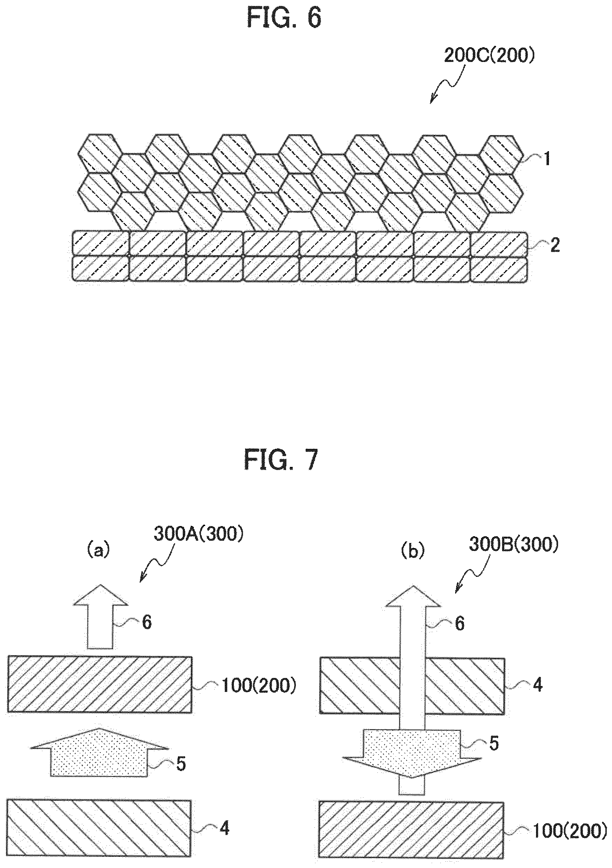

A description will be given of a wavelength converter according to a fourth embodiment with reference to the drawings. FIG. 6 is a schematic diagram illustrating the wavelength converter according to the second embodiment. As illustrated in FIG. 6, a wavelength converter 200C (200) includes a sintered body of a first warm-color phosphor 1 and a sintered body of a second warm-color phosphor 2. Specifically, the wavelength converter 200C is one in which the sintered body of the first warm-color phosphor 1 and the sintered body of the second warm-color phosphor 2 are brought into close contact with each other.

Here, the sintered body of the first warm-color phosphor 1 of the wavelength converter 200C is one in which the first warm-color phosphor 1 that constitutes the warm-color complex phosphor 100 according to the first embodiment is sintered. Moreover, the sintered body of the second warm-color phosphor 2 of the wavelength converter 200C is one in which the second warm-color phosphor 2 that constitutes the warm-color complex phosphor 100 according to the first embodiment is sintered.

Note that, in FIG. 6, the sintered body of the first warm-color phosphor 1 is illustrated as one in which two particles of the first warm-color phosphor 1 are stacked on each other in the vertical direction in this drawing, and the sintered body of the second warm-color phosphor 2 is illustrated as one in which three particles of the second warm-color phosphor 2 are stacked on each other in the vertical direction in this drawing. However, FIG. 6 is a schematic diagram, and the number of stacked particles of first warm-color phosphor 1, which constitute the sintered body of the first warm-color phosphor 1, and the number of stacked particles of second warm-color phosphor 2, which constitute the sintered body of the second warm-color phosphor 2, are not particularly limited.

Moreover, in FIG. 6, the wavelength converter 200C is illustrated on the premise that there are relatively large gaps between the sintered body of the first warm-color phosphor 1 and the sintered body of the second warm-color phosphor 2. However, FIG. 6 is a schematic diagram, and between the sintered body of the first warm-color phosphor 1 and the sintered body of the second warm-color phosphor 2, only small gaps to an extent where these can be brought into close contact with each other by using a binding agent to be described later are present.

Moreover, in FIG. 6, the sintered body of the first warm-color phosphor 1 is disposed in the upper direction in this drawing, and the sintered body of the second warm-color phosphor 2 is disposed in the lower direction in this drawing. However, as a modified example of the wavelength converter 200C, the sintered body of the second warm-color phosphor 2 can be disposed in the upper direction in this drawing, and the sintered body of the first warm-color phosphor 1 can be disposed in the lower direction in this drawing.

A first warm-color phosphor 1 that constitutes the sintered body of the above-described first warm-color phosphor 1 and a second warm-color phosphor 2 that constitutes the sintered body of the above-described second warm-color phosphor 2 are the same as the first warm-color phosphor 1 and the second warm-color phosphor 2 which constitute the warm-color complex phosphor 100 according to the first embodiment. Therefore, in the following description of the wavelength converter 200C according to this embodiment, the description of the first warm-color phosphor 1 and the second warm-color phosphor 2 will be omitted or simplified.

### <Sintered body of first warm-color phosphor and sintered body of second warm-color phosphor>

The sintered body of the first warm-color phosphor 1 is obtained by sintering the first warm-color phosphor 1 that is a raw material. Moreover, the sintered body of the second warm-color phosphor 2 is obtained by sintering the second warm-color phosphor 2 that is a raw material.

### <Close contact of sintered body of first warm-color phosphor and sintered body of second warm-color phosphor>

As a method for bringing the sintered body of the first warm-color phosphor 1 and the sintered body of the second warm-color phosphor 2 into close contact with each other, for example, a method of adhering the sintered body of the first warm-color phosphor 1 and the sintered body of the second warm-color phosphor 2 to each other, or the like is used.

For the adhesion of the sintered body of the first warm-color phosphor 1 and the sintered body of the second warm-color phosphor 2, for example, a binding agent such as low-melting-point glass is used. Specifically, there is used a method of adhering the sintered body of the first warm-color phosphor 1 and the sintered body of the second warm-color phosphor 2 to each other by a molten and coagulated binding agent obtained by heating and cooling the binding agent disposed between the sintered body of the first warm-color phosphor 1 and the sintered body of the second warm-color phosphor 2.

Thus, the wavelength converter 200C in which the sintered body of the first warm-color phosphor 1 and the sintered body of the second warm-color phosphor 2 are in close contact with each other, the wavelength converter 200C being illustrated in FIG. 6, is obtained.

Note that, when the wavelength converter 200C is made of only an inorganic material, the wavelength converter 200C becomes excellent in thermal conductivity, in which high heat dissipation design is easy, and accordingly, this is preferable.

Preferably, the wavelength converter 200C does not include another substance other than phosphors, and particularly, another substance other than the first warm-color phosphor 1 and the second warm-color phosphor 2. In the wavelength converter 200C that has such a configuration, factors to lose photons by light absorption are completely eliminated, and accordingly, it becomes easy to increase an output thereof. Moreover, the wavelength converter 200C that has such a configuration absorbs excitation light efficiently, and can thereby increase an output ratio of the fluorescent component subjected to wavelength conversion by the wavelength converter 200C. Therefore, the wavelength converter 200C that has such a configuration becomes a wavelength converter suitable for a reflection-type light emitting device.

Moreover, preferably, the wavelength converter 200C includes a translucent inorganic compound as another substance than the phosphors. As the translucent inorganic compound, for example, alumina and silica are used.

The wavelength converter 200C that has such a configuration makes it easy for the excitation light to optically pass therethrough, and accordingly, makes it difficult to inhibit such optical transmission of the excitation light. Therefore, the wavelength converter 200C that has such a configuration becomes a wavelength converter suitable for a transmission-type light emitting device.

### <Functions>

Functions of the wavelength converter 200C, which relate to excitation and fluorescence, are the same as the functions of the warm-color complex phosphor 100 according to the first embodiment. Therefore, a description of the functions of the wavelength converter 200C, which relate to excitation and fluorescence, will be omitted.

### <Effects>

According to the wavelength converter 200C, a variety of warm-color light components can be obtained by changing the intensity ratio of the blue light component and the green light component in the excitation light.

Moreover, the wavelength converter 200C radiates the fluorescence including the orange to red light component, and accordingly, becomes a wavelength converter suitable for the purpose such as illumination and display.

### [Light emitting device]

### (Fifth and sixth embodiments)

A description will be given of light emitting devices according to fifth and sixth embodiments.

The light emitting devices according to the fifth and sixth embodiments widely include electronic devices provided with functions to emit light, and are not particularly limited as long as are electronic devices which emit any kind of light. Moreover, the light emitting devices also include an illumination light source, an illuminating device, a display device and the like. Therefore, an illuminating device, a projector or the like, which is provided with a laser diode, is also regarded as such a light emitting device.

Each of the light emitting devices according to the fifth and sixth embodiments uses the warm-color complex phosphor 100 according to the first embodiment as a wavelength conversion material. That is, each of the light emitting devices according to the fifth and sixth embodiments is a device that includes the warm-color complex phosphor 100 according to the first embodiment and uses, as output light, the fluorescence radiated by the warm-color complex phosphor 100. Each of the light emitting devices according to the fifth and sixth embodiments is one formed by combining the warm-color complex phosphor 100 or the wavelength converter 200 and an excitation source, which excites the warm-color complex phosphor 100, with each other. The first warm-color phosphor 1 and the second warm-color phosphor, which are included in the warm-color complex phosphor 100, absorb energy radiated by the excitation source, and converts the absorbed energy into fluorescence of which color tone is controlled.

A description will be given below of the light emitting devices according to the fifth and sixth embodiments with reference to the drawings. FIG. 7 illustrates outlines of the light emitting devices according to the fifth and sixth embodiments. In FIG. 7, FIG. 7(a) illustrates a light emitting device 300A (300) according to the fifth embodiment, and FIG. 7(b) illustrates a light emitting device 300B (300) according to the sixth embodiment.

In FIG. 7(a) and FIG. 7(b), an excitation source 4 is a light source that generates excitation light 5 for exciting the phosphors included in the warm-color complex phosphor 100 according to the first embodiment or the wavelength converter 200 according to the second embodiment. As the excitation source 4, a radiating device can be used, which radiates a particle beam (an α ray, a β ray, an electron beam or the like) or an electromagnetic wave (a γ ray, an X ray, a vacuum ultraviolet ray, an ultraviolet ray, visible light or the like). Note that, preferably, a radiating device that radiates blue light and/or green light is used as the excitation source 4.

As the excitation source 4, there can be used varieties of radiation generating devices, electron beam radiating devices, discharge light generating devices, solid-state light emitting elements, solid-state light emitting devices, and the like. A typical excitation source 4 includes an electron gun, an X-ray tube, a rare gas discharge device, a mercury discharge device, a light emitting diode, a laser beam generating device including a semiconductor laser, an inorganic or organic electroluminescence element, and the like.

In FIG. 7(a) and FIG. 7(b), output light 6 is an excitation line radiated by the excitation source 4, or fluorescence radiated by the phosphors in the wavelength converter 100, which are excited by the excitation light 5. Then, the output light 6 is used as illumination light or display light in the light emitting devices.

In the light emitting device 300A according to the fifth embodiment, which is illustrated in FIG. 7(a), the output light 6 from the phosphors is emitted in a direction where the wavelength converter 100 is irradiated with the excitation line or the excitation light 5. Note that, as the light emitting device 300A, for example, a fluorescent lamp, an electron tube and the like are used as well as a white LED light source and a transmission-type laser illuminating device.

Meanwhile, in the light emitting device 300B according to the sixth embodiment, which is illustrated in FIG. 7(b), the output light 6 from the wavelength converter 100 is emitted in a reverse direction to the direction where the wavelength converter 100 is irradiated with the excitation line or the excitation light 5. The light emitting device 300B is used, for example, as a reflection-type laser illuminating device, for example, a light source device, a projector and the like, each of which uses a reflective plate-attached phosphor wheel.

Preferable ones as specific examples of the light emitting devices 300Aand 300B are semiconductor light emitting devices, illumination light sources, illuminating devices, display devices and the like, each of which is configured by using phosphors, and particularly, are laser illuminations and laser projectors.

Each of the light emitting devices 300A and 300B includes a solid-state light emitting element. In each of the light emitting devices 300A and 300B, preferably, the first warm-color phosphor 1 and the second warm-color phosphor 2, which are included in the wavelength converter 200, convert the excitation light emitted by the solid-state light emitting element into light having a longer wavelength than the excitation light. Moreover, preferably, the solid-state light emitting element radiates blue light or green light, and particularly preferably, radiates blue light. Use of the solid-state light emitting element as the excitation source makes it possible to achieve an all-solid-state light emitting device resistant to impact, for example, solid-state illumination. The light emitting device as described above can be suitably used for any purpose of outdoor illumination, store illumination, a dimming system, facility illumination, ocean illumination, a projector, and an endoscope.

Each of the light emitting devices 300A and 300B includes either the warm-color complex phosphor 100 or the wavelength converter 200. Each of the light emitting devices 300A and 300B is one formed by combining the warm-color complex phosphor 100 or the wavelength converter 200 and the excitation source, which excites the warm-color complex phosphor 100, with each other.

Since the warm-color complex phosphor 100 radiates, as output light, the fluorescence including the orange to red light component, each of the light emitting devices 300A and 300B can use the fluorescence for the purpose of illumination, display and the like.

Note that, preferably, the output light radiated by each of the light emitting devices 300A and 300B is used as illumination light or display pixels. In this case, each of the light emitting devices 300A and 300B is used as an illuminating device or a display device.

Moreover, each of the light emitting devices 300A and 300B includes the warm-color complex phosphor or the wavelength converter, which includes the Ce³⁺-activated phosphor having ultrashort afterglow properties. Moreover, since saturation of the fluorescence output is suppressed, each of the light emitting devices 300A and 300B can obtain high-output light emission even under a condition of being excited by high-density light.

Preferably, each of the light emitting devices 300A and 300B includes a particulate phosphor that functions as a light scattering body. According to each of the light emitting devices 300A and 300B, which has such a configuration, it becomes possible to radiate output light in which glittering looking due to a coherent effect intrinsic to laser light is suppressed and orientation characteristics approximate to the Lambertian distribution are provided.

Preferably, each of the light emitting devices 300A and 300B includes the wavelength converter 200 made of an inorganic compound excellent in thermal conductivity. In each of the light emitting devices 300A and 300B, which has this configuration, heat of the wavelength converter 200, which is generated following the excitation by the high-density light, is radiated efficiently, and the temperature quenching of the phosphors is suppressed. Hence, according to the light emitting devices 300A and 300B, which has this configuration, it becomes possible to obtain high-output light.

In each of the light emitting devices 300A and 300B, preferably, the excitation source 4 includes a semiconductor light emitting element. The semiconductor light emitting element such as a light emitting diode (LED) and a laser diode (LD) is a small solid-state element. Therefore, according to each of the light emitting devices 300A and 300B, which has the above-described configuration, a light emitting device that is small and highly reliable is obtained.

In each of the light emitting devices 300A and 300B, preferably, the excitation source 4 further includes a phosphor. As the excitation source 4 including a phosphor, for example, a white LED is used, in which an LED that radiates blue fluorescence and a garnet phosphor that radiates green fluorescence are combined with each other. Moreover, as the excitation source 4 including a phosphor, for example, a white LD is used, in which an LD that radiates blue fluorescence and a garnet phosphor that radiates green fluorescence are combined with each other.

When each of the light emitting devices 300A and 300B is configured as described above, it becomes easy to obtain light components of blue light and green light, which are required for exciting the warm-color complex phosphor, while reducing the number of semiconductor light emitting elements which are relatively expensive. Therefore, each of the light emitting devices 300A and 300B, which has such a configuration, is useful in terms of industrial production.

Preferably, the excitation source 4 radiates a blue light component that has a fluorescence peak within a wavelength range of 440 nm or more and less than 480 nm and a green light component that has a fluorescence peak within a wavelength range of 500 nm or more and less than 550 nm. Moreover, preferably, the blue light component radiated by the excitation source 4 has a fluorescence peak within a blue wavelength range of 445 nm or more and less than 470 nm. Furthermore, preferably, the green light component radiated by the excitation source 4 has a fluorescence peak within a green wavelength range of 510 nm or more and less than 540 nm.

When the excitation source 4 of each of the light emitting devices 300A and 300B has such a configuration, the Ce³⁺-activated orange phosphor that is the first warm-color phosphor 1 and the Ce³⁺-activated red phosphor that is the second warm-color phosphor 2 can be excited efficiently. Therefore, according to each of the light emitting devices 300A and 300B, which has such a configuration, it becomes easy for a light component that has an intense warm color to be included in the output light.

Preferably, each of the light emitting devices 300A and 300B is configured so that the intensities of the blue light component and the green light component, which are radiated by the excitation source 4, are controlled independently of each other.

When each of the light emitting devices 300A and 300B has such a configuration, an intensity ratio of the blue light component and the green light component can be changed arbitrarily, and a color tone range of outputtable light is widened.

In each of the light emitting devices 300A and 300B, preferably, a fluorescence spectrum half width of the blue light component is wider than a half width of an excitation band of the Ce³⁺-activated orange phosphor (first warm-color phosphor 1). When each of the light emitting devices 300A and 300B has the above-described configuration, the Ce³⁺-activated orange phosphor efficiently absorbs the blue light component radiated by the excitation source 4, and accordingly, it becomes easy for the light component that has an intense warm color to be included in the output light. Moreover, in each of the light emitting devices 300A and 300B, preferably, the fluorescence spectrum of the above-described blue light component includes the excitation band of the Ce³⁺-activated orange phosphor (first warm-color phosphor 1).

Here, the half width of the fluorescence spectrum means a wavelength difference between longer and shorter wavelengths where the intensity of the fluorescence spectrum of the phosphor such as the Ce³⁺-activated orange phosphor becomes 0.5 when the fluorescence spectrum is normalized so that a maximum intensity thereof becomes 1.0. This definition of the half width of the fluorescence spectrum is also applied to a fluorescence spectrum half width of the green light component and a half width of an excitation band of the Ce³⁺-activated red phosphor (second warm-color phosphor 2), which will be described later.

For example, in the first warm-color phosphor 1 illustrated in FIG. 2, a half width of the fluorescence spectrum (1em in FIG. 2) is 144 nm (687 nm - 543 nm), and a half width of the excitation band (1ex in FIG. 2) is 91 nm (519 nm - 428 nm). Therefore, it is seen that, in the first warm-color phosphor 1 illustrated in FIG. 2, the fluorescence spectrum half width of the blue light component is wider than the half width of the excitation band of the Ce³⁺-activated orange phosphor (first warm-color phosphor 1).

In each of the light emitting devices 300A and 300B, preferably, the fluorescence spectrum half width of the green light component is wider than the half width of the excitation band of the Ce³⁺-activated red phosphor (second warm-color phosphor 2). When each of the light emitting devices 300A and 300B has the above-described configuration, the Ce³⁺-activated red phosphor efficiently absorbs the green light component radiated by the excitation source 4, and accordingly, it becomes easy for the light component that has an intense warm color to be included in the output light. Moreover, in each of the light emitting devices 300A and 300B, preferably, the fluorescence spectrum of the above-described green light component includes the excitation band of the Ce³⁺-activated red phosphor (second warm-color phosphor 2).

In the second warm-color phosphor 2 illustrated in FIG. 2, a half width of the fluorescence spectrum (2em in FIG. 2) is 162 nm (747 nm - 585 nm), and a half width of the excitation band (2ex in FIG. 2) is 76 nm (572 nm - 496 nm). Therefore, it is seen that, in the second warm-color phosphor 2 illustrated in FIG. 2, the fluorescence spectrum half width of the green light component is wider than the half width of the excitation band of the Ce³⁺-activated red phosphor (second warm-color phosphor 2).

In each of the light emitting devices 300A and 300B, preferably, the semiconductor light emitting element is a laser diode, and the light emitting device does not include another phosphor than the Ce³⁺-activated phosphors.

When each of the light emitting devices 300A and 300B has such a configuration, it becomes easy to form a point light source with high output since only the Ce³⁺-activated phosphors which have ultrashort afterglow properties and are less likely to cause the saturation of the fluorescence output by laser light are used.

A light density of the laser light applied to the wavelength converter 200 is, for example, 3 W/mm² or more and less than 100 W/mm². When the light density is less than 3 W/mm², a difference from LED illumination that does not apply laser light becomes unclear. Therefore, with regard to a light emitting device with a light density of less than 3 W/mm², a value thereof as a differentiated product becomes likely to decrease. Meanwhile, when the light density exceeds 100 W/mm², heat generation caused by an energy loss of the wavelength converter 200 may occur.

A light density (maximum value) of laser light 101, which is preferable for use in general illumination, is 3 W/mm² or more and less than 20 W/mm². A light density (maximum value) of the laser light 101, which is preferable for use in an endoscope, is 10 W/mm² or more and less than 50 W/mm². A light density (maximum value) of the laser light 101, which is preferable for use in a projector, is 40 W/mm² or more and less than 100 W/mm².

When each of the light emitting devices 300A and 300B is any of an illumination light source, an illuminating device, an illuminating system, a display device, and a display system, then this is preferable since each of the light emitting devices 300A and 300B is suitable for the purpose of illumination and the purpose of display, which are demanded much. Moreover, each of the light emitting devices 300A and 300B can also be applied to a light emitting device that uses IoT and AI.

### <Functions>

Functions of the light emitting devices 300A and 300B, which relate to excitation and fluorescence, are the same as the functions of the warm-color complex phosphor 100 according to the first embodiment. Therefore, a description of the functions of the wavelength converter 200C, which relate to excitation and fluorescence, will be omitted.

### <Effects>

According to the light emitting devices 300A and 300B, a variety of warm-color light components can be obtained by changing the intensity ratio of the blue light component and the green light component in the excitation light.

### EXAMPLES

A more detailed description will be given below of this embodiment by examples; however, this embodiment is not limited to these examples.

### [Example 1]

### (Excitation spectra and fluorescence spectra of respective phosphors)

As the first warm-color phosphor 1, a powdery Lu₂CaMg₂(SiO₄)₃:Ce³⁺ orange phosphor (fluorescence peak wavelength λp ≈ 597 nm, median particle size D₅₀ ≈ 13 µm) was prepared. As the second warm-color phosphor 2, a powdery La₃(Si,Al)6N₁₁:Ce³⁺ red phosphor (fluorescence peak wavelength λp ≈ 630 nm, median particle size D₅₀ ≈ 10 µm) was prepared. The excitation spectra and fluorescence spectra of the first warm-color phosphor 1 and the second warm-color phosphor 2 are as illustrated in FIG. 2.

### (Excitation spectra and fluorescence spectra used in simulation)

The fluorescence spectrum of the warm-color complex phosphor for each of the excitation wavelengths, the warm-color complex phosphor being composed by mixing the first warm-color phosphor 1 and the second warm-color phosphor 2 with each other, can be simulated relatively easily, and it was confirmed that an obtained simulation result is approximate to an experimental result. Therefore, the functions and effects of the warm-color complex phosphor 100 were confirmed by the simulation.

Note that, among the fluorescent component of the Lu₂CaMg₂(SiO₄)₃:Ce³⁺ orange phosphor, a fluorescent component in a wavelength range that overlaps the excitation spectrum of the La₃(Si,Al)₆N₁₁:Ce³⁺ red phosphor is subjected to wavelength conversion into red light. Specifically, among the fluorescent component of the above-described orange phosphor, the fluorescent component in the wavelength range that overlaps the excitation spectrum of the red phosphor interferes with the above-described red phosphor, is absorbed to the above-described red phosphor, and is subjected to wavelength conversion into red light. Therefore, in order to enhance accuracy, this simulation was implemented in consideration of the above-described interference effect.

More specifically, a maximum value of a light absorption rate of the La3(Si,Al)₆N₁₁:Ce³⁺ red phosphor was set to 70%. The reason why the maximum value of the light absorption rate was set to 70% is that a maximum value thereof in practical use was assumed to 70%. Next, it was assumed that the intensity of the fluorescent component of the Lu₂CaMg₂(SiO₄)₃:Ce³⁺ orange phosphor decreased in the wavelength range (500 to 600 nm) where the fluorescence spectrum of the orange phosphor and the excitation spectrum of the La₃(Si,Al)6N₁₁:Ce³⁺ red phosphor overlap each other. This assumption was made in consideration that the intensity of the fluorescent component of the orange phosphor is absorbed by the red phosphor in the above-described wavelength range (500 to 600 nm). Note that the decrease of the intensity of the fluorescent component of the orange phosphor was set on the assumption that a fluorescence spectrum shape of the orange phosphor was directly affected by light absorption characteristics of the red phosphor, which were different for each of the wavelengths, and was changed for each of the wavelengths. Then, the fluorescence spectrum obtained under the above-described prerequisite was assumed to be the fluorescence spectrum of the Lu₂CaMg₂(SiO₄)₃:Ce³⁺ orange phosphor, and was used for the simulation.

Moreover, in order to simplify the simulation, it was assumed that the excitation spectra of the orange phosphor and the red phosphor and the fluorescence spectrum of the red phosphor do not substantially have an interference effect following the mixing of the phosphors. Then, a mixing ratio of such mixed phosphors was set to a ratio in which each of the orange phosphor and the red phosphor has a maximum value of the fluorescence spectrum intensity at the excitation peak wavelength, the maximum value being equal to a maximum value in the other phosphor.

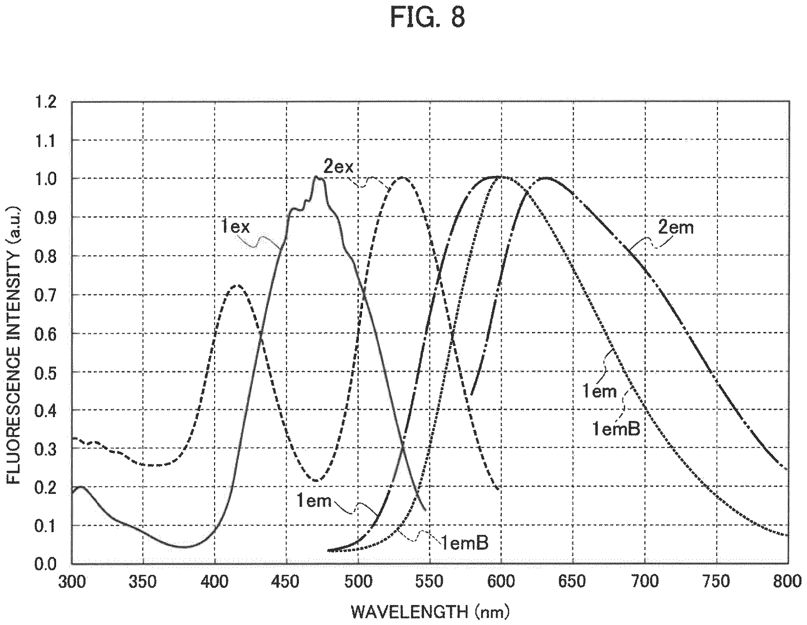

FIG. 8 is a diagram illustrating respective excitation spectra and respective fluorescence spectra of the first warm-color phosphor and the second warm-color phosphor which are used in the simulation. Specifically, FIG. 8 is a graph illustrating, in addition to the respective excitation spectra and the respective fluorescence spectra in the first warm-color phosphor and the second warm-color phosphor, which are illustrated in FIG. 2, a fluorescence spectrum of the first warm-color phosphor, which is corrected in consideration of the interference effect of both of the phosphors.

In FIG. 8, as in FIG. 2, the excitation spectrum of the Lu₂CaMg₂(SiO₄)₃:Ce³⁺ orange phosphor that is the first warm-color phosphor 1 is represented as 1ex, and the fluorescence spectrum of the same phosphor is represented as 1em. Moreover, in FIG. 8, as in FIG. 2, the excitation spectrum of the La₃(Si,Al)6N₁₁:Ce³⁺ red phosphor that is the second warm-color phosphor 2 is represented as 2ex, and the fluorescence spectrum of the same phosphor is represented as 2em.

Furthermore, in FIG. 8, the fluorescence spectrum of the first warm-color phosphor, which is corrected in consideration of the interference effect of both of the above-described phosphors, is represented as 1emB. Note that, in FIG. 8, the fluorescence spectra 1em and 1emB of the first warm-color phosphor coincide with each other in a wavelength range of 600 nm or more.

### (Simulation results)

A description will be given below of simulation results of exciting the obtained warm-color complex phosphor by various types of excitation light.

### <Case of exciting pieces of monochromatic light different in wavelength>

First, a description will be given of simulation results of fluorescence spectra in the case of excitation by pieces of monochromatic light different in wavelength.

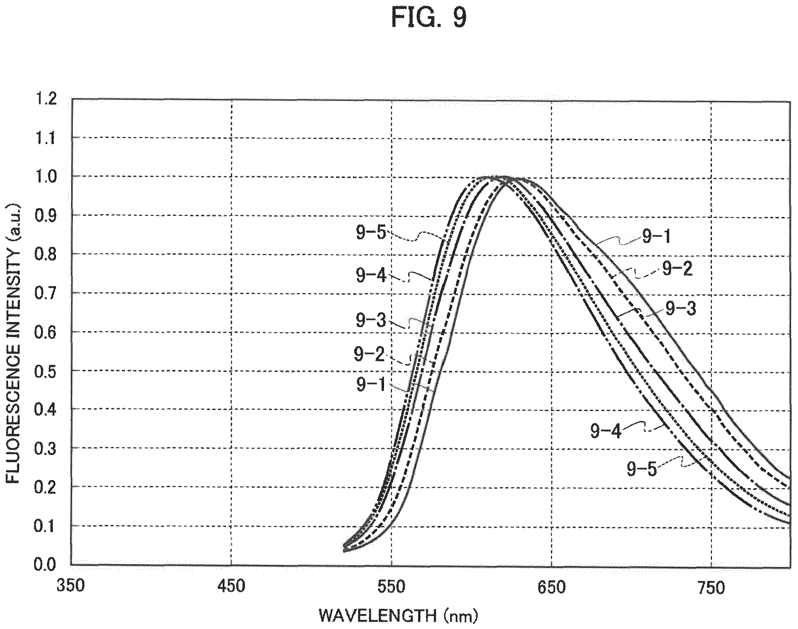

FIG. 9 is simulation results of fluorescence spectra in the case of excitation by pieces of monochromatic light in which a wavelength is changed within a wavelength range of 450 nm to 550 nm. Specifically, FIG. 9 is simulation results of fluorescence spectra in the case where, as excitation light, there are used pieces of monochromatic light in which a wavelength is changed every 25 nm within a wavelength range of 450 nm to 550 nm, which covers from blue to green.

In FIG. 9, fluorescence spectra in the case of excitation using pieces of monochromatic light with wavelengths of 450 nm, 475 nm, 500 nm, 525 nm and 550 nm are represented as 9-1, 9-2, 9-3, 9-4, and 9-5, respectively.

From FIG. 9, it is seen that, in the case of excitation using blue monochromatic light within a wavelength of 450 to 475 nm, the warm-color complex phosphor according to this embodiment functions as a reddish orange phosphor that radiates reddish orange light with a wavelength of approximately 610 nm.

Moreover, it is seen that, in the case of excitation using green monochromatic light having a lower wavelength than the blue monochromatic light, the fluorescence peak wavelength becomes longer as the excitation light becomes longer.

Note that, in the case of excitation using green monochromatic light with a wavelength of 550 nm, the warm-color complex phosphor according to this embodiment functions as a red phosphor that radiates red light with a fluorescence peak wavelength of 630 nm.

It is seen that, as described above, the warm-color complex phosphor according to this embodiment is a warm-color complex phosphor that can control the color tone of the red light component by the color tone of the excitation light within the wavelength range of blue to green.

### <Case of using excitation light in which intensity ratio of blue monochromatic light and green monochromatic light is changed>

Next, a description will be given of simulation results of fluorescence spectra in the case of using the excitation light in which the intensity ratio of the blue monochromatic light and the green monochromatic light is changed. Specifically, a description will be given of simulation results of fluorescence spectra in the case of using, as excitation light, dichromatic light in which an intensity ratio of blue monochromatic light with a wavelength of 470 nm and green monochromatic light with a wavelength of 530 nm differs.

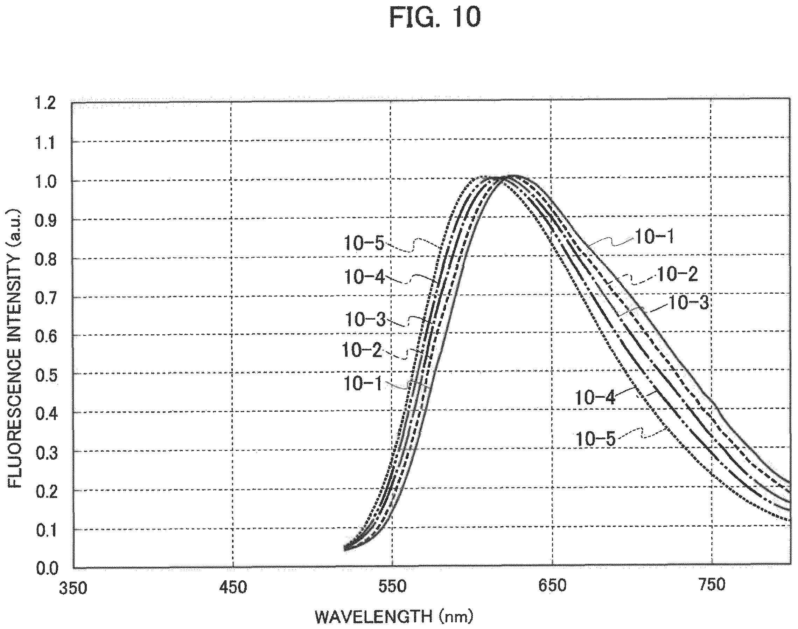

FIG. 10 is simulation results of fluorescence spectra in the case of using excitation light in which the intensity ratio of the blue monochromatic light and the green monochromatic light is changed. Specifically, FIG. 10 is simulation results of fluorescence spectra when, among mixed light of the blue monochromatic light and the green monochromatic light, pieces of light in which an intensity ratio of the green monochromatic light is changed every 25% from 0% to 100% are used as such excitation light.

In FIG. 10, a fluorescence spectrum in the case of excitation using mixed light composed of 0% of blue monochromatic light with a wavelength of 470 nm and 100% of green monochromatic light with a wavelength of 530 nm is represented as 10-1. Moreover, a fluorescence spectrum in the case of excitation using mixed light composed of 25% of the above-described blue monochromatic light and 75% of the above-described green monochromatic light is represented as 10-2. Furthermore, a fluorescence spectrum in the case of excitation using mixed light composed of 50% of the above-described blue monochromatic light and 50% of the above-described green monochromatic light is represented as 10-3. Moreover, a fluorescence spectrum in the case of excitation using mixed light composed of 75% of the above-described blue monochromatic light and 25% of the above-described green monochromatic light is represented as 10-4. Furthermore, a fluorescence spectrum in the case of excitation using mixed light composed of 100% of the above-described blue monochromatic light and 0% of the above-described green monochromatic light is represented as 10-5.

From FIG. 10, it is seen that, in the case of excitation using single light of blue monochromatic light within a wavelength of 470 nm (10-5), the warm-color complex phosphor according to this embodiment functions as a reddish orange phosphor that radiates reddish orange light with a fluorescence peak wavelength of 608 nm.

Then, it is seen that the fluorescence peak wavelength becomes longer as the intensity ratio of the green monochromatic light increases, and that the warm-color complex phosphor according to this embodiment functions as a red phosphor that radiates red light with a fluorescence peak wavelength of 630 nm in the case of being excited by single light of green monochromatic light with a wavelength of 530 nm (10-1).

It is seen that, as described above, the warm-color complex phosphor according to this embodiment becomes the warm-color phosphor that can control the color tone of the red light component by the intensity ratio of the blue light component and the green light component which constitute the excitation light.

### <Case of excitation using white light sources different in color tone>

Finally, a description will be given of simulation results of fluorescence spectra in the case of using, as excitation light, pieces of output light radiated by white light sources different in color tone from one another.

As the white light sources, white light sources are used, in each of which a blue laser diode (blue LD, fluorescence peak wavelength: 450 nm) and a Y₃Al₂(AlO₄)₃:Ce³⁺ green phosphor (fluorescence peak wavelength: 540 nm) are combined with each other.

Specifically, as the above-described white light sources, three types of white light sources which radiate the following three types of white output light (white excitation light) were used.
[White excitation light 1] correlated color temperature: 29693 K, duv: -17
[White excitation light 2] correlated color temperature: 5371 K, duv: 23
[White excitation light 3] correlated color temperature: 4361 K, duv: 54

Note that color tones of the white light sources can be controlled by controlling light absorption rates of wavelength converters including the above-described Y₃Al₂(AlO₄)3:Ce³⁺ green phosphor.

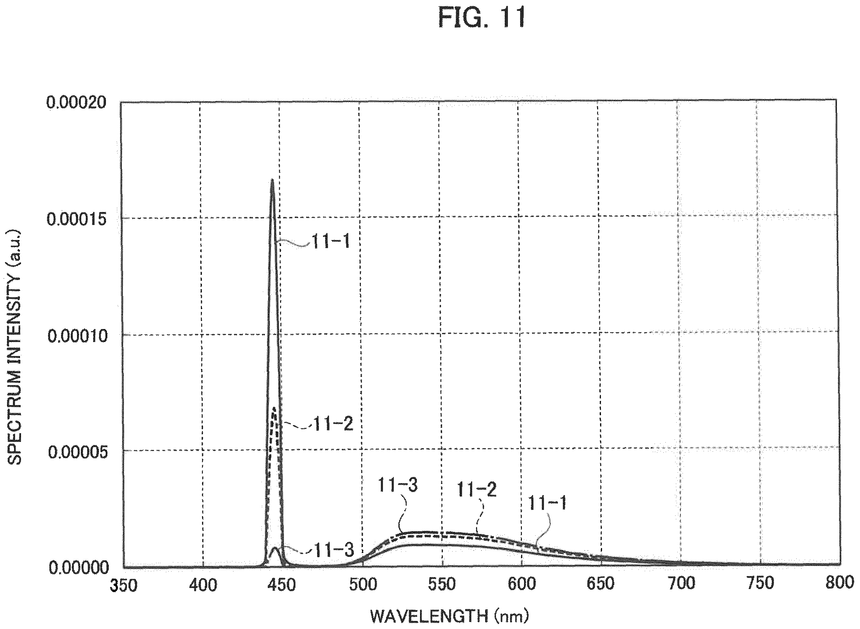

FIG. 11 is spectral distribution maps of the white excitation light radiated by the three types of white light sources different in color tone from one another. In FIG. 11, the spectral distribution maps of the white excitation light 1, the white excitation light 2 and the white excitation light 3 are represented as 11-1, 11-2 and 11-3, respectively.

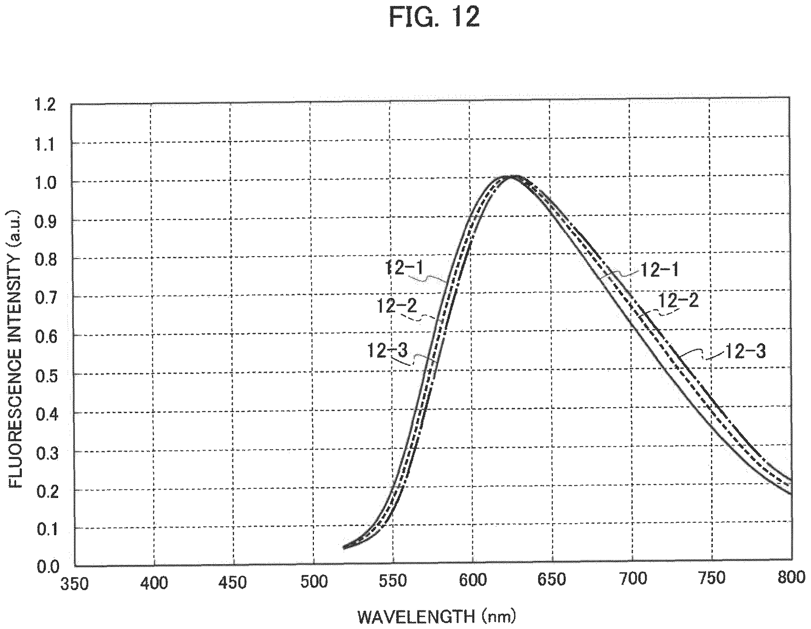

FIG. 12 is simulation results of fluorescence spectra in the case of using the three types of white excitation light illustrated in FIG. 11. In FIG. 12, simulation results of the fluorescence spectra in the case of using the white excitation light 1, the white excitation light 2 and the white excitation light 3 as excitation light are represented as 12-1, 12-2 and 12-3, respectively.

From FIG. 12, it is seen that, in the case of excitation using the white excitation light 1, the white excitation light 2 and the white excitation light 3, the warm-color complex phosphor according to this embodiment functions as red phosphors which radiate pieces of red light which have fluorescence peak wavelengths of 622 nm, 625 nm and 630 nm, respectively, and are different in color tone from one another.

It is seen that, as described above, the warm-color complex phosphor according to this embodiment is a warm-color complex phosphor that can control the color tone of the red light component by the light colors of the pieces of white excitation light radiated by the white light sources.

### <Summary of simulation results>

By the above-described three types of simulation results, it is seen that the warm-color complex phosphor according to this embodiment can obtain a variety of warm-color light components by the control for the blue light component and the green light component which serve as the excitation light of the warm-color complex phosphor.

Therefore, it is seen that the warm-color complex phosphor according to this embodiment can radiate warm-color light components with a variety of color tones by only using one type of warm-color complex phosphor including two types of warm-color phosphors. Moreover, it is seen that the warm-color complex phosphor according to this embodiment easily copes with a variety of purposes by using only one type of warm-color complex phosphor.

The entire contents of Japanese Patent Application No. 2018-179960 (filed on: September 26, 2018) are incorporated herein by reference.

Although the contents of this embodiment have been described above in accordance with the examples, it is obvious to those skilled in the art that this embodiment is not limited to the description of these and that various modifications and improvements are possible.

### INDUSTRIAL APPLICABILITY

According to the present disclosure, there can be provided the warm-color complex phosphor, the wavelength converter and the light emitting device, which are capable of obtaining a variety of warm-color light components by changing the intensity ratio of the blue light component and the green light component in the excitation light.

### REFERENCE SIGNS LIST

- 1: First warm-color phosphor
- 2: Second warm-color phosphor
- 3: Transparent resin
- 4: Excitation source
- 5: Excitation light
- 6: Output light
- 100: Warm-color complex phosphor
- 200, 200A, 200B, 200C: Wavelength converter
- 300, 300A, 300B: Light emitting device

## Claims

1. A warm-color complex phosphor comprising:
a Ce³⁺-activated orange phosphor that has an excitation peak within a blue wavelength range of 440 nm or more and less than 480 nm and has a fluorescence peak within an orange wavelength range of 580 nm or more and less than 610 nm; and
a Ce³⁺-activated red phosphor that has an excitation peak within a green wavelength range of 500 nm or more and less than 550 nm and has a fluorescence peak within a red wavelength range of 610 nm or more and less than 660 nm.

2. The warm-color complex phosphor according to claim 1, wherein the Ce³⁺-activated red phosphor is a nitride-based compound.

3. The warm-color complex phosphor according to claim 2, wherein the Ce³⁺-activated red phosphor is a La₃Si₆N₁₁-type nitride-based compound that has a La₃Si₆N₁₁-type crystal structure.

4. The warm-color complex phosphor according to any one of claims 1 to 3, wherein the Ce³⁺-activated orange phosphor is garnet-type silicate.

5. The warm-color complex phosphor according to any one of claims 1 to 4, wherein the Ce³⁺-activated orange phosphor is a Lu₂CaMg₂(SiO₄)₃-based compound that has a crystal structure of Lu₂CaMg₂(SiO₄)₃ or a Lu₂CaMg₂(SiO₄)₃ solid solution in which an end member is Lu₂CaMg₂(SiO₄)₃.

6. The warm-color complex phosphor according to claim 5, wherein the Ce³⁺-activated orange phosphor is the Lu₂CaMg₂(SiO₄)₃-based compound, and the Ce³⁺-activated red phosphor is the La₃Si₆N₁₁-type nitride-based compound.

7. A wavelength converter comprising the warm-color complex phosphor according to any one of claims 1 to 6.

8. The wavelength converter according to claim 7, wherein the wavelength converter is made of only an inorganic material.

9. A light emitting device, wherein the warm-color complex phosphor according to any one of claims 1 to 6 or the wavelength converter according to claim 7 or 8 and an excitation source that excites the warm-color complex phosphor are combined with each other.

10. The light emitting device according to claim 9, wherein the excitation source includes a semiconductor light emitting element.

11. The light emitting device according to claim 10, wherein the excitation source further includes a phosphor.

12. The light emitting device according to claim 10 or 11, wherein the excitation source radiates a blue light component that has a fluorescence peak within a wavelength range of 440 nm or more and less than 480 nm and a green light component that has a fluorescence peak within a wavelength range of 500 nm or more and less than 550 nm.

13. The light emitting device according to claim 12, wherein intensity of the blue light component radiated from the excitation source and intensity of the green light component radiated from the excitation source are controlled independently of each other.

14. The light emitting device according to claim 12 or 13, wherein a fluorescence spectrum half width of the blue light component is wider than a half width of an excitation band of the Ce³⁺-activated orange phosphor.

15. The light emitting device according to any one of claims 12 to 14, wherein a fluorescence spectrum half width of the green light component is wider than a half width of an excitation band of the Ce³⁺-activated red phosphor.

16. The light emitting device according to claim 10, wherein the semiconductor light emitting element is a laser diode, and the light emitting device does not include another phosphor than the Ce³⁺-activated phosphors.

17. The light emitting device according to any one of claims 9 to 16, wherein the light emitting device is any of an illumination light source, an illuminating device, an illuminating system, a display device, and a display system.
